Europäisches Patentamt

(19) European Patent Office

Office européen des brevets

(11) Numéro de publication: **0 001 361**
**B1**

(12) **FASCICULE DE BREVET EUROPEEN**

(45) Date de publication du fascicule de brevet: **13.05.81**

(51) Int. Cl.³: **H 01 L 29/78,**
**H 01 L 27/10, H 03 H 15/00**

(21) Numéro de dépôt: **78400082.0**

(22) Date de dépôt: **29.08.78**

(54) **Dispositif à transfert de charges électriques et filtre transversal à transfert de charges comportant un tel dispositif.**

(30) Priorité: **23.09.77 FR 7728737**

(43) Date de publication de la demande:
**04.04.79 Bulletin 79/7**

(45) Mention de la délivrance du brevet:
**13.05.81 Bulletin 81/19**

(84) Etats Contractants Désignés:
**DE GB NL**

(56) Documents cités:
**FR - A - 2 302 636**
**NL - A - 77 11861**

(73) Titulaire: **THOMSON-CSF**
**173, Boulevard Haussmann**
**F-75360 Paris Cedex 08 (FR)**

(72) Inventeur: **Berger, Jean-Luc**
**"THOMSON-CSF" 173 bld Haussmann**
**F-75360 Paris Cedex 08 (FR)**
Inventeur: **Bourrat, Michel**
**"THOMSON-CSF" 173 bld Haussmann**
**F-75360 Paris Cedex 08 (FR)**

(74) Mandataire: **Benichou, Robert et al,**
**"THOMSON-CSF" - SCPI 173 bld Haussmann**
**F-75360 Paris Cedex 08 (FR)**

Courier Press, Leamington Spa, England.

## Dispositif à transfert de charges électriques et filtre transversal à transfert de charges comportant un tel dispositif

La présente invention est relative à un dispositif à transfert de charges électriques de précision dans lequel un partage des charges échantillons est effectué au cours du transfert, par exemple un filtre transversal à transfert de charges.

On rapelle qu'un filtre transversal à transfert de charges est, de manière générale, consitué par un substrat de matériau semi-conducteur recouvert d'un matériau isolant sur lequel sont disposées des électrodes. Celles-ci assurent, par application périodique de potentiels déterminés, le transfert dans le subtrat de charges électriques échantillons représentant le signal à traiter. Une première série d'électrodes, appelées électrodes de transfert, et une deuxième série d'électrodes, appelées électrodes de pondération, sont disposées parallèlement les unes aux autres et transversalement par rapport à la direction de transfert des charges. Les électrodes des de transfert et les électrodes de pondération sont intercalées, les électrodes de pondération présentant chacune une coupure parallèle au sens de transfert des charges et séparant chaque électrode en deux parties distinctes. La valeur des coefficients de pondération est déterminée par la position de chaque coupure sur l'électrode de pondération correspondante. Le signal à traiter est représenté par un paquet de charges réparti uniformément sous les électrodes. Lorsque ce paquet de charges arrive sous une électrode de pondération présentant une coupure, celui-ci induit au niveau de chaque partie de l'electrode correspondante un courant de déplacement proportionnel aux surfaces respectives des deux parties. L'intégration du courant de déplacement induit au niveau de chaque électrode donne, en sortie du dispositif, un signal proportionnel au signal d'entrée affecté d'un coefficient qui dépend de la position de la coupure sur chaque électrode de pondération. Les limites du canal de transfert des charges peuvent être définies par des zones de diffusion d'isolement créées sur le substrat de matériau semi-conducteur. Pour une largeur des électrodes de pondération constante suivant la direction de transfert des charges, la précision des coefficients de pondération dépend de la position de la coupure par rapport aux limites du canal.

Selon les techniques habituelles, la coupure de dimension g suivant une direction perpendiculaire à la direction de transfert disposée au niveau de chaque électrode de pondération et la diffusion des zones d'isolement déterminant les limites du canal sont obtenues par deux opérations de photogravure différentes avec un positionnement optique des masques de photogravure l'un par rapport à l'autre. La longueur d'une électrode comprise entre les limites du canal étant à égale à L, chaque partie distincte des électrodes de pondération a une longueur égale à $\alpha$ (L-g) et à $(1-\alpha)$ (L-g) et l'incertitude sur la longueur $\alpha$ (L-g) est, du fait des opérations distinctes de photogravure, de l'ordre de 2 à 3 micromètres. Une solution connue pour éviter cet inconvénient consiste à disposer dans le substrat et au niveau de la coupure de chaque électrode de pondération une zone de diffusion d'isolement. Cette zone de diffusion d'isolement, de longueur 1 selon une une direction perpendiculaire à la direction de transfert, est obtenue en même temps que les zones de diffusion d'isolement définissant les limites du canal. On obtient ainsi un auto-positionnement de chaque coupure, la zone de diffusion d'isolement se comportant comme une coupure de longueur 1, et un partage des charges électriques au niveau des parties d'électrode de chaque électrode de pondération suivant les longueurs $\alpha$ (L-1) et $(1-\alpha)$ (L-1) du fait de la non conduction de la région de diffusion et de l'absence, au niveau de cell-ci, de champ électrique permettant le transfert des charges. L'inconvénient de cette solution réside dans le fait qu'une fraction de la charge représentative du signal est bloquée par la zone de diffusion d'isolement. Cette fraction de la charge représentative du signal s'écrit

$$q = \frac{1}{L}Q$$

où Q représente la quantité totale de charge d'un paquet de charges représentatif d'un échantillon du signal d'entrée. Cette fraction de charge q est en partie transférée sous l'électrode de pondération mais la répartition au niveau de chaque partie distincte d'électrode se fait de manière imprécise.

L'importance de la quantité

$$q = \frac{1}{L}Q$$

est fonction de la valeur des dimensions 1 et L. La longueur L est choisie la plus grande possible de l'ordre de 600 micromètres par exemple. La dimension g de chaque coupure dans und direction orthogonale à la direction du transfert, est supérieure à 3 micromètres et la longueur 1 minimum de chaque région de diffusion d'isolement est de l'ordre de 13 micromètres, compte tenu de tirage dû aux traitements thermiques à haute température effectués postérieurement à l'opération de diffusion ou d'implantation. La quantité

$$\frac{1}{L}$$

est donc de l'ordre de

$$\frac{2}{100}$$

et la charge bloquée au niveau de chaque région de diffusion d'isolement représente

$$\frac{2}{100}$$

de la charge échantillon représentative du signal entraînant sur celui-ci une imprécision correspondante. A ce facteur d'imprécision il faut ajouter le risque d'une recombination de cette fraction de charge dans le substrat si celle-ci n'atteint par une zone de champ électrique, entraînant le transfert, avant la commutation des potentiels périodiques appliqués aux électrodes. Chaque électrode de transfert, disposée entre chaque électrode de pondération, permet d'obtenir à nouveau un paquet de charges homogènes.

On connaît dans l'art antérieur par la demande de brevet français N° 75.06252 publiée sous le N° 2.302.636 au nom de THOMSON-CSF un filtre à transfert de charges dans lequel une électrode de pondération coupée en deux parties est précédée par une électrode de transfert comportant sur toute sa largeur une zone de diffusion d'isolement au niveau de la coupure de l'électrode de pondération suivante. La quantité de charges représentative du signal qui est bloquée par la zone de diffusion d'isolement est toujours de l'ordre de

$$q = \frac{1}{L}.$$

Q et de plus la répartition des charges au niveau de chaque partie d'électrode de pondération se fait toujours de façon imprécise.

La présente invention a pour objet un dispositif à transfert de charges comportant un substrat semi-conducteur recouvert d'une couche isolante sur laquelle sont disposées des électrodes de transfert intercalées avec des electrodes de pondération assurant le partage des charges, l'ensemble des électrodes assurant sur application de potentiels donnés le transfert des charges dans le substrat. Chaque électrode de pondération est constituée par au moins deux électrodes élémentaires séparées selon le sens de transfert, par une coupure au niveau de laquelle, le substrat comporte une zone de diffusion d'isolement. Chaque électrode de transfert comporte une zone de diffusion d'isolement constituée par le prolongement de la zone d'isolement disposée au niveau de la coupure de l'électrode de pondération qui la suit, selon le sens de transfert des charges. La dimension

$r = D - p_1$, où D représente la dimension des électrodes de transfert, selon le sens de transfert et où $p_1$ représente la dimension de la zone de diffusion au niveau des électrodes de transfert, selon le sens de transfert, est sensiblement égale à D/3.

La présente invention résoud le problème de diminuer fortement la fraction de charge représentative d'un échantillon du signal d'entrée qui est perturbée par la pondération.

Un gain en précision du dispositif, de l'ordre de 5, peut être ainsi obtenu tout en permettant d'obtenir une densité de charges homogènes sous chaque électrode de transfert. Le dispositif selon l'invention permet également de réduire fortement le risque de recombinaison d'une fraction de charges dans le substrat.

L'invention sera mieux comprise à l'aide de la description et des dessins ci-après où les cotes et proportions relatives des différents éléments n'ont pas été respectées et où les mêmes éléments portent les mêmes références et dans lesquels:

— la figure 1 représente un dispositif à transfert de charges selon l'art connu dans lequel le partage de la charge est effectué au niveau de chaque électrode de pondération,

— la figure 2 représente un mode de réalisation non limitatif de dispositif objet de l'invention dans le cas d'un filtre transversal à transfert de charges.

La figure 2 représente une vue de dessus du dispositif selon l'invention.

Les différentes figures sont relatives de façon non limitative à une filtre transversal à transfert de charges, ce dispositif comporte un substrat de matériau semi-conducteur 10 sur lequel est disposée une couche isolant. Le matériau semi-conducteur est par exemple du silicium et le matériau isolant de l'oxyde de silicium $SiO_2$. Des électrodes de transfert référencées 1, 3, 5, 7 et des électrodes de pondération référencées 2, 4, 6, sont disposées sur la couche isolante. Un étage d'injection 11 des charges dans le semi-conducteur réalise la transformation du signal d'entrée en un paquet de charges représentant celui-ci. La direction du transfert des charges est indiquée par une flèche. Les limites du canal de transfert des charges peuvent être définies par des zones de diffusion d'isolement 102 et 103 créées sur le substrat de matériau semi-conducteur 10. La longueur des électrodes comprise entre les limites du canal est égale à L. Leur largeur peut être constante et égale à D. Les électrodes de pondération sont intercalées avec les électrodes de transfert et assurent le partage de paquets de charges. Les électrodes de pondération sont constituées chacune par au moins deux électrodes élémentaires séparées, suivant la direction du transfert des charges, par une coupure référencée respectivement 20, 40, 60 pour les électrodes 2, 4, 6, et de dimension g suivant une direction orthogonale à la direction de transfert. Le substrat de matériau semi-conducteur 10 peut comporter au niveau de la coupure de chaque électrode de pondération une zone de diffusion d'isolement référencée respectivement 200, 400 et 600, et de longueur 1, selon une direction orthogonale à la direction de transfert, chaque partie distincte des électrodes de pondération a donc une longueur égale à $\alpha$ (L-1) et à (1-$\alpha$) (L-1).

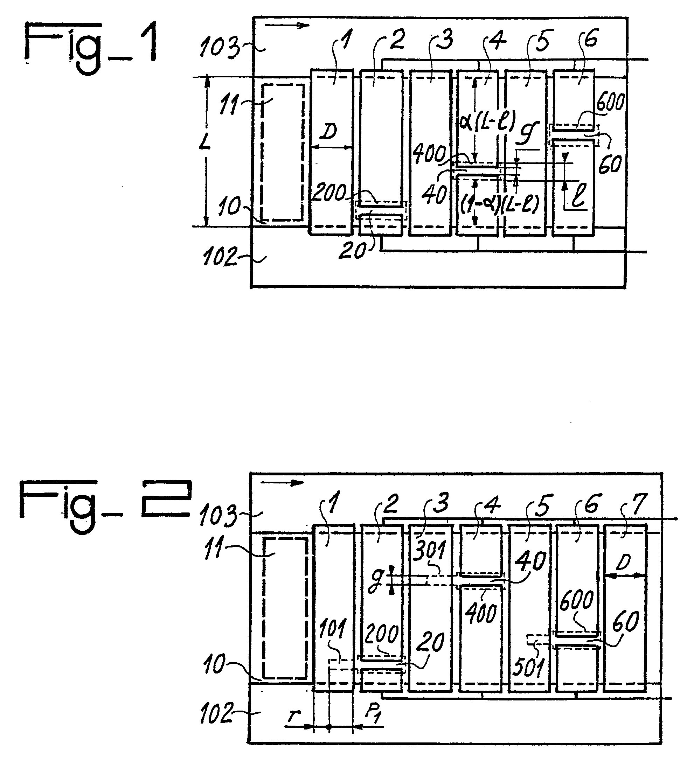

La figure 1 représente donc un dispositif à transfert de charges selon l'art connu dans lequel, comme cela a été expliqué précédemment, une fraction

$$q = \frac{1}{L}.Q$$

de la charge représentative du signal est bloquée par les zones de diffusion d'isolement 200, 400, 600.

La figure 2 représente un mode de réalisation non limitatif du dispositif objet de l'invention dans le cas d'un filtre transversal à transfert de charges. Sur la figure 2, selon la direction du transfert, en vis-à-vis de chaque coupure, une zone de diffusion d'isolement référencée 101, 301, 501 est disposée au niveau d'une électrode de transfert précédant, selon le sens de transfert des charges, chaque électrode de pondération. La zone de diffusion d'isolement disposée au niveau de l'électrode de transfert précédant chaque électrode de pondération permet d'effectuer un pré-partage de la charge échantillon sous chaque electrode de transfert. La zone de diffusion d'isolement disposée au niveau de l'éléctrode de transfert précédant chaque électrode de pondération a, de préférence, une dimension suivant une direction orthogonale à la direction de transfert, voisine de la dimension g, selon la même direction, de la coupure de l'électrode de pondération correspondante. La plus grande dimension $p_1$, selon la direction de transfert définie par la flèche, de chaque zone de diffusion d'isolement, telle que 101, 301, 501, disposée au niveau d'une électrode de transfert, est telle que $p_1 < D$, $p_1$ inférieur à D, où D représente la dimension de l'électrode de transfert correspondante dans cette même direction avec $D - p_1 = r$.

La dimension r, telle que $D - p_1 = r$ représente pour chaque électrode de transfert, la distance libre maximale, suivant la direction du transfert des charges et en vis-à-vis de chaque zone de diffusion, située au niveau de chaque électrode de transfert. La dimension r est choisie suffisamment importante pour que, compte tenu de la fréquence de fonctionnement du dispositif et de la fréquence de transfert des charges le temps de stationnement de chaque paquet de charges représentatif d'un échantillon du signal d'entrée au niveau de la distance libre de dimension r de chaque électrode de transfert permette une uniformisation de la densité de charge avant la pré-séparation de chaque paquet de charges par la zone de diffusion correspondante. Ainsi une conduction entre les deux portions d'électrode de transfert reste possible ce qui permet avant la phase de pré-separation, d'obtenir und densité de charge homogène sous chaque électrode de transfert.

La zone de diffusion d'isolement 101, 301, 501 disposée au niveau de chaque électrode de transfert 1, 3, 5 est constituée par le prolongement de la zone de diffusion d'isolement 200, 400, 600, disposée au niveau de la coupure de l'électrode de pondération 2, 4, 6, suivante selon le sens de transfert des charges.

En ce qui concerne le mode de réalisation représenté sur la figure 2, lors du transfert seule une fraction de charge $q' = (rg/DL).Q$ est bloquée par la zone de diffusion d'isolement correspondante. La valeur de r est sensiblement égale à

$$\frac{D}{3}$$

où D est la dimension de l'électrode de transfert suivant le sens de transfert.

Compte tenu d'une valeur de g, dimension de la zone de diffusion d'isolement dans une direction perpendiculaire au transfert des charges, égale à 7 micromètres, la fraction de charge qui risque d'être perturbée est de l'ordre de 0.4%. On obtient ainsi un gain en précision de l'ordre de 5. La fraction de charge recombinée est également beaucoup plus réduite.

Le mode de réalisation de l'invention représenté sur la figure 2 est relatif à un filtre transversal á transfert de charges comportant un nombre déterminé d'électrodes.

Le dispositif objet de l'invention peut être utilisé dans tout système de traitement du signal, tout dispositif à transfert de charges comportant un nombre quelconque d'électrodes et dans lequel une préséparation de la charge échantillon est effectuée par une zone de diffusion d'isolement disposée au niveau des électrodes de transfert ne sort pas du cadre de la présente invention.

**Revendications**

1. Dispositif à transfert de charges électriques comportant un substrat semi-conducteur recouvert d'une couche isolante sur laquelle sont disposées des électrodes de transfert (1, 3, 5) intercalées avec des électrodes de pondération (2, 4, 6) assurant le partage des charges, l'ensemble des électrodes assurant sur application de potentiels donnés le transfert des charges dans le substrat et chaque électrode de pondération étant constituée par au moins deux électrodes élémentaires séparées, selon le sens du transfert, par une coupure (20, 40, 60) au niveau de laquelle le substrat comporte une zone de diffusion d'isolment (200, 400, 600), caractérisé en ce que le substrat de matériau semi-conducteur comporte au niveau de chaque électrode de transfert une zone de diffusion d'isolement (101, 301, 501) constituée par le prolongement de la zone d'isolement (200, 400, 600) disposée au niveau de la coupure de l'électrode de pondération suivante selon le sens du transfert, la dimension r des électrodes de transfert, selon le sens du transfert et en vis-à-vis de la coupure de l'électrode de pondération suivante, qui est telle que $r = D - p_1$, où D représente la dimension, selon le sens du transfert, des électrodes de transfert (1, 3, 5) et où $p_1$ représente la dimension selon le sens du transfert, de la zone d'isolement (101, 301, 501) sous chaque électrode de transfert, étant sensiblement égale à D/3.

2. Dispositif selon la revendication 1, caractérisé en ce que la dimension, selon une direction orthogonale au sens du transfert, de la zone d'isolement (101, 301, 501) sous chaque électrode de transfert (1, 3, 5) est sensiblement égale à la dimension (g), selon la même direction, de la coupure (20, 40, 60) de l'électrode de pondération suivante, selon la sans du transfert.

3. Filtre transversal à transfert de charges électriques, caractérisé en ce qu'il comporte un dispositif à transfert de charges électriques selon l'une des revendications 1 ou 2.

## Claims

1. Electrical charge transfer device comprising a semi-conductor substrate covered with an insulating layer on which transfer electrodes (1, 3, 5) are arranged, weighting electrodes (2, 4, 6) ensuring the separation of the charges being intercalated between said transfer electrodes, transfer and weighting electrodes ensuring the transfer of charges in the substrate on the application of given potentials and each weighting electrode being formed by at least two elementary electrodes separated, in the transfer direction, by an interruption, (20, 40, 60), the substrate comprising, at the level of the interruption an insulating diffusion zone (200, 400, 600), wherein the substrate of semi-conductor material comprises, at the level of each transfer electrode, an insulating diffusion zone (101, 301, 501), formed by the extension of the insulating zone (200, 400, 600) disposed at the level of the interruption of the following weighting electrode in the transfer direction, the dimension r of the transfer electrodes in the transfer direction and opposite to the interruption of the following weighting electrode, which is such that $r = D - p_1$ where D represents the dimension, in the transfer direction, of the transfer electrodes (1, 3, 5) and where $p_1$ represents the dimension, in the transfer direction, of the insulating zone (101, 301, 501) under each transfer electrode, being approximately equal to D/3.

2. Device according to claim 1, wherein the dimension, in a direction orthogonal to the transfer direction, of the insulating zone (101, 301, 501) under each transfer electrode (1, 3, 5) is approximately equal to the dimension (g), in the same direction of the interruption (20, 40, 60) of the following weighting electrode in the transfer direction.

3. A transversal charge transfer filter, wherein it comprises a charge transfer device according to one of the claims 1 or 2.

## Patentansprüche

1. Vorrichtung zur Übertragung von elektrischen Ladungen mit einem Halbleiter-Träger, der mit einer Isolierschicht bedeckt ist, auf welcher in abwechselnder Reihenfolge Übertragungselektroden (1, 3, 5) und die Ladungen teilende Bewertungselektroden (2, 4, 6) angeordnet sind, wobei die Elektroden in ihrer Gesamtheit bei Anlegen gegebener Potentiale die Ladungen auf den Träger übertragen und jede Bewertungselektrode aus wenigstens zwei Elektrodenteilen besteht, zwischen denen in Übertragungsrichtung gesehen eine Unterbrechung (20, 40, 60) vorgesehen ist und wobei der Träger im Bereich der Unterbrechung eine Streuungsisolierzone (200, 400, 600) aufweist, dadurch gekennzeichnet, dass der aus Halbleitermaterial bestehende Träger im Bereich jeder der Übertragungselektroden eine Streuungsisolierzone (101, 301, 501) aufweist, die durch die Verlängerung der im Bereich der Unterbrechung der in Übertragungsrichtung gesehen nachfolgenden Bewertungselektrode angeordneten Isolierzone (200, 400, 600) gebildet ist, und dass die Abmessung r der Übertragungselektroden in Übertragungsrichtung und gegenüber der Unterbrechung der nachfolgenden Bewertungselektrode gemessen wesentlich gleich D/3 ist, wobei die Abmessung r derart gewählt ist, dass $r = D - p_1$ und wobei D die in Übertragungsrichtung gemessene Abmessung der Übertragungselektroden (1, 3, 5) und $p_1$ die in Übertragungsrichtung gemessene Abmessung der unter jeder Übertragungselektrode ungeordneten Isolierzone (101, 301, 501) darstellen.

2. Vorrichtung nach Anspruch 1, dadurch gekennzeichnet, dass die in einer in bezug auf die Übertragungsrichtung orthogonalen Richtung gemessene Abmessung der unter jeder Übertragungselektrode (1, 3, 5) vorgesehenen Isolierzone (101, 301 501) der in der gleichen Richtung gemessenen Abmessung (g) der Unterbrechung (20, 40, 60) der in Übertragungsrichtung betrachtet nachfolgenden Bewertungselektrode gleich ist.

3. Transversalfilter zur Übertragung elektrischer Ladungen, dadurch gekennzeichnet, dass es eine Vorrichtung zur Übertragung von elektrischen Ladungen nach einem der Ansprüche 1 oder 2 aufweist.

Fig_1

Fig_2